(19) Europäisches Patentamt
European Patent Office
Office européen des brevets

(11) Publication number: **0 315 073 A2**

# (12) EUROPEAN PATENT APPLICATION

(21) Application number: 88118013.7

(22) Date of filing: 28.10.88

(51) Int. Cl.4: G03F 7/08

(30) Priority: 02.11.87 JP 277605/87
18.07.88 JP 177105/88

(43) Date of publication of application:
10.05.89 Bulletin 89/19

(84) Designated Contracting States:
DE FR GB

(71) Applicant: Matsushita Electric Industrial Co., Ltd.
1006, Oaza Kadoma
Kadoma-shi Osaka-fu, 571(JP)

(72) Inventor: Endo, Masayuki
782, Kurodoricho
Izumi-shi(JP)
Inventor: Sasago, Masaru
1-3-14, Kohoku-1-chome
Hirakata-shi(JP)
Inventor: Ueno, Atushi
52-9, Nagao Motomachi-7-chome
Hirakata-shi(JP)
Inventor: Nomura, Noboru
35, Fukakusa Nakanoshimacho
Fushimi-ku Kyoto(JP)
Inventor: Ogawa, Kazufumi
30-5, Higashinakaburi-1-chome
Hirakata-shi(JP)

(74) Representative: Patentanwälte Leinweber & Zimmermann
Rosental 7/II Aufg.
D-8000 München 2(DE)

## (54) A composition for pattern forming materials.

(57) A composition comprising copolymers of styrene and maleic acid or its derivatives, and a cross-linkable photosensitive substance or acridine or an acridine derivative is provided for pattern forming material. A miniaturized pattern having a high sensitivity and a high contrast can be obtained by exposing said composition to far ultraviolet or excimer laser rays since said polymer has high transmission to those rays when cured.

EP 0 315 073 A2

# A COMPOSITION FOR PATTERN FORMING MATERIALS

## BACKGROUND OF THE INVENTION

The present invention relates to a composition for pattern forming materials (resists) usuable for lithography processes in the manufacture of semiconductors, especially lithography using far ultraviolet rays and excimer rays.

As the demand for miniaturized semiconductor elements increases, the employment of excimer laser rays which are far ultraviolet rays having a great resolving power becomes promising in the lithography step which is one of the steps for producing semiconductor elements (See V. Pol et al, Proc. of SPIE, 633, 6 (1986)). There has been hitherto a big problem in the case of negative resist materials among the resist materials suitable for lithography using far ultraviolet rays (around 190 - 320 nm) and excimer laser rays (193 nm, 248 nm, 308 nm). That is, the conventional negative resists exhibit too great absorption of far ultraviolet rays and excimer laser rays (The transmission at 248 nm is generally 20% or less in case of the resist having a thickness of 1 µm) to transmit well into the lower area of the resist and therefore the reaction in this area only proceeds with difficulty. As a result, the pattern formed becomes of inverted trapezoid shape or the resist pattern peals off from the substrate.

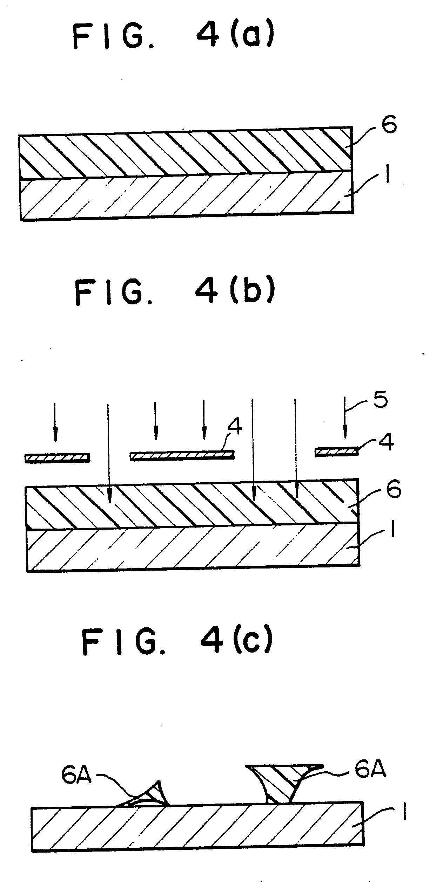

By referring to Fig. 4, the process for forming the pattern is explained by using one of the conventional pattern forming materials and a negative resist for ultraviolet rays RD-2000N (mfd. by Hitachi Chemicals Co., Ltd.).

RD-2000N which is a negative resist is coated on substrate 1 and oven-baked at 80° C for 20 minutes to give a resist film 3 of 1.0 µm thickness (Fig. 4a). The transmission of rays at 248 nm in the case of this resist film is 17%. Then, KrF excimer laser rays 5 are selectively exposed to the film through a mask 4 by using a KrF excimer stepper (248 nm; NA: 0.35) (Fig. 4b). The amount of the exposure is 200 $mJ/cm^2$ and the transmission of the thus obtained resist is 25%. Resist pattern 6A is formed by developing with an alkaline developer, RD-developer (Hitachi Chemicals Co., Ltd.) for 60 seconds (Fig. 4c).

Thus formed pattern 6A of 1 µm thickness is of inverted trapezoid shape and about 0.5 µm of that may flow over onto the pattern near-by because of weak adhesiveness to the substrate derived from the inverted trapezoid shape since the rays can not penetrate into the lower area of the resist due to poor transmission of the rays. Those patterns mentioned above are unsuitable as a mask for the next etching step, and thus, the fluctuation in the size or the defect in pattern occurs and this leads to decrease in the yield of semiconductor devices.

Generally, it is well-known that novolak resins, phenolic resins, maleimide resins, copolymers of styrene and maleic acid derivatives and the like themselves have a property of the capability of forming negative resist by negative-type polymerization with DUV rays, excimer rays or the like.

The application of those resins themselves as negative resist for DUV is not suitable for miniaturized semiconductor devices since they are poor in both sensitivity and resolving power (namely, their sensitivity for KrF excimer laser rays is $10^4$ $mJ/cm^2$ or more, and their resolution capability is about 1.0 µm).

## SUMMARY OF THE INVENTION

The object of the present invention is to provide a composition for pattern forming material free from inverted trapezoid shape derived from over absorption of the irradiated ray and having a miniaturized and high sensitivity and high contrast pattern resolving power.

The present composition provides pattern forming materials free from the drawbacks of the conventional ones and comprising copolymers of styrene and maleic acid derivatives, and cross-linkable photosensitive substance, or acridine or acridine derivatives and novolak resins, phenolic resins, maleimide resins or copolymers of styrene and maleic acid derivatives as a main component.

## BRIEF DESCRIPTION OF THE DRAWINGS

Figs. 1 and 3 are schematic section views of the pattern forming process in which the composition of the present invention is employed. Fig. 2 is an ultraviolet spectroscopy. Fig. 4 are schematic section views of the pattern forming process in which the conventional pattern forming material is employed.

1 ... substrate, 2, 3 ... the material of the present invention, 4 ... mask, 5 ... KrF excimer laser rays, 6 ... conventional pattern forming material (RD-2000N), 2A, 3A, 6A ... pattern

## DETAILED DESCRIPTION OF THE INVENTION

One of the main components of the present pattern forming material is a polymer. As such a polymer, mention will be made of copolymers of styrene and maleic acid derivatives (In this specification, the term "maleic acid derivatives" sometimes includes maleic acid itself), novolak resins, phenolic resins, maleimide resins.

The copolymers of styrene and maleic acid derivatives may have the following structural unit in the molecule:

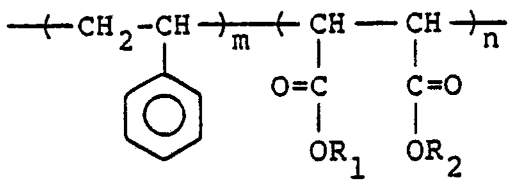

or

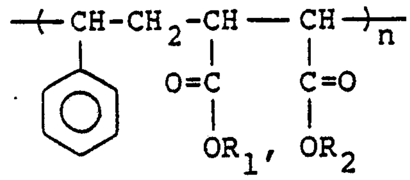

wherein m and n are both any intergers, respectively, and $R_1$ and $R_2$ are hydrogen atoms, alkyl groups, cycloalkyl groups, aryl groups which may have the substituents, allyl groups, alkenyl groups, alkinyl groups. The alkyl group may be substituted with a halogen atom(s). As substituents for the aryl group, mention may be made of alkyl group, alkenyl group, halogen atom, and the like. Both alkenyl group and alkinyl groups may be substituted by halogen atom, aryl group or the like. $OR_1$ or $OR_2$ radical may be replaced by a halogen atom such as fluorine, bromine or chlorine atom.

The molecular weight of polymer usuable in the present invention may be 1,500 to 20,000, preferably 3,000 to 10,000.

The amount of polymer to be used in the present composition is usually determined depending upon the purposes for use and kind of polymer to be used, but can be chosen in the same range as that of the conventional amounts. The amount of the polymer in the composition, however, is usually chosen from 50% to 95% by weight based on the resist. The amount of the cross-linkable photo-sensitive substance is preferably 5% to 50% by weight and that of the polymer is preferably to 50% to 95% by weight. The composition is preferably prepared by using 10 to 40% by weight of a solvent based on the total weight of the polymer and the cross-linkable photosensitive substance. Of course, the present composition is not limited to said amounts. Furthermore, any conventional materials usually used for the pattern forming material can also be added.

The ratio of styrene to the maleic derivatives can be randomly chosen. The term "maleic derivatives" includes maleic acid, maleic mono- and di-ester and the like. As novolak resins, phenolic resins or maleimide resins, any commercial available polymer can be used as far as they can meet the requirements as a polymer for the negative resist.

Copolymers of styrene and maleic acid derivatives are preferable because they have a high transmission of the rays having a wavelength in the vicinity of 248 nm corresponding to far ultraviolet rays, especially KrF excimer laser rays, and show 80% or more transmission in a film thickness of 1 µm. Furthermore, the copolymers of said series do not swell in an alkaline solution, and the present inventors have found if a cross-linkable photosensitive substance is added to this polymer, the exposed area of the polymer in an alkaline solution becomes insoluble, thereby negative resist is formed.

If alkaline soluble styrene copolymers is used in the present composition, it can transmit the irradiated rays to a considerably great extent and thus the rays can easily be transmitted to the lower area of the coated pattern forming material because these copolymers have a transparency of 50% higher than the polymers conventionally used ones for and ultraviolet rays, far ultraviolet rays, thereby the formation of inverted-trapezoid shaped pattern can be prevented. Therefore, alkaline soluble styrene copolymers may be used alone as a polymer in the present composition, too.

As is discussed above, the present inventive pattern forming material (the negative resist) does not form a pattern having an inverted trapezoid shape since the irradiated rays can be transmitted easily to the lower area of the resist because of the transparency of the polymer, and thus it can provide high resolution pattern due to nonswellable property of the polymer in an alkaline condition.

Additionally, the copolymers of styrene and maleic acid derivatives of the present invention are very useful from the viewpoint of the etching resistance due to the existence of aromatic nuclei.

As a cross-linkable photosensitive substance of the present invention, any cross-linkable photosensitive substance can be used without any limitation as far as it has a sensitivity to far ultraviolet rays, excimer laser rays and the like. That is, diazonium salt compounds, diazo compounds, azido compounds can be illustrated. As an example of the azido compounds, mention will be made of the compounds having the following general formula

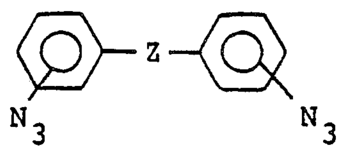

wherein Z denotes $-CH_2-$, $-CH_2CH_2-$, $-CH=CH-$,

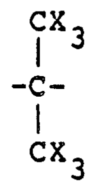

(in which X is a halogen atom or hydrogen atom), -S-, -S-S-,

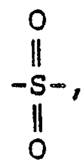

or 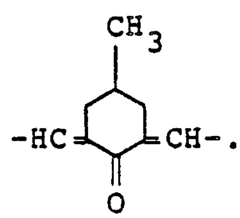

In the case that the melting point of these cross-linkable photosensitive substances is lower than or equal to the temperature for prebaking the present pattern forming material coated on the substrate so as to form the pattern, the pattern forming material thermally cross-links at the surface area contacting to the substrate, whereby the formation of inverted trapezoid-shaped pattern can be prevented under certain conditions, which results in the formation of reliable pattern.

The present composition for pattern forming material may contain polymers such as for example xylenol resins, cresol resins and like and the compounds such as bisphenol A, catechol so as to adjust the solvability of the present inventive polymers, the other polymers usuable in the present composition and cross-linkable photosensitive substance in the solvents used for dissolving those materials mentioned above; and sensitizers for improving the photosensitivity such as

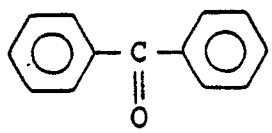 , 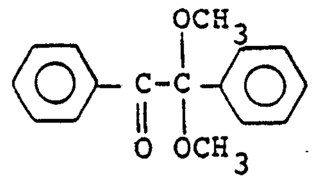 ,

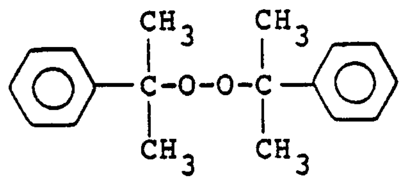 and the like.

and the like.

As a solvent usuable in the present invention, mention will be made of cyclohexanone, diethylene glycol, dimethyl ether, ethylcellosolve acetate, xylene, cyclopentane and the like. A mixture of these solvents may also be used.

The present composition for a pattern forming material can be used as a material of negative resist for ultraviolet rays in the case that a cross-linkable photosensitive substance of the present invention is reactive to ultraviolet rays since the present polymer shows high transparency in the ultraviolet range.

Furthermore, the present inventors have found that acridine and its derivatives can also act as a cross-linkable photosensitive substance when DUV light rays or excimer laser rays are irradiated on a composition containing acridine or its derivatives and a polymer such as novolak resins, phenol resins, maleimide resins and the like. In that case, the sensitivity and resolution capability of the negative resist can be increased.

The amount of acridine or a derivative thereof to be added is about 1% by weight based on the weight of the polymer in the composition, and this amount is sufficient for its activity to be shown.

In the present composition, azido compounds are preferably used since the unexposed area still has a good solubility in an alkaline aqueous solution while the exposed area becomes insoluble in the alkaline aqueous solution due to the increase in the molecular weight as a result of the reaction between; the polymer and the $N_3$ group of azido compounds. Thus, the unexposed area can easily be removed from the substrate to give negative resist. As is aforementioned, the present composition does not form inverted trapezoid-shaped patterns, and the difference in the unexposed and the exposed area is quite apparent. Therefore, the aspect ratio of the thus obtained pattern is excellent. Furthermore, the film loss in the exposed area cannot be expected due to the action of the azido compounds while the styrene copolymers are generally very soluble in an alkaline solution.

The azido compounds of the present invention may be any commercially available ones and they can be shown by the general formula aforementioned. Additionally,

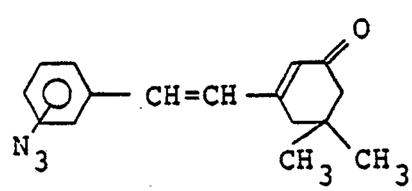

can be added. Of course, a mixture of them can be used.

The amount of the azido compounds is 100% by weight or less based on the weight of the polymer in the composition. If this amount is more than 100% by weight, the reaction between the polymer and the azido compound is depressed due to the reaction among the azido compound itself when exposed to the ray, thereby the formation of the pattern is disturbed.

As is aforementioned, the other cross-linkable photosensitive substance can be used in the present composition.

Furthermore, if acridine or one of acridine derivatives is used as a cross-linkable photosensitive substance in the pattern forming material, the present inventors have found that there is formed a pattern having high resolution and high aspect ratio. In this case, phenolic resins, maleimide resins, novolac resins can be used in combination with the copolymers of styrene and maleic acid derivatives or alone. Of course, any of other resins usuable as a pattern forming polymer can be used together with acridine or a acridine

derivative.

The present invention will be explained in detail with referring to Examples, however, the present invention is not limited thereto.

## Examples

### Example 1

An embodiment of the present composition for pattern forming material is explained by referring to Fig. 1.

The present composition for pattern forming material was prepared by mixing the following materials:

A polymer having the structural unit of

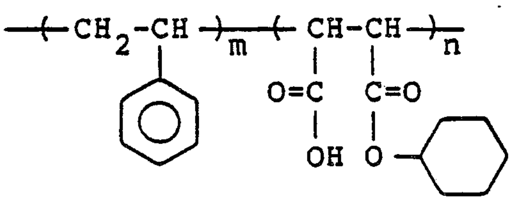

10 g,

wherein m to n is 1 : 1 and the molecular weight of 6000

| | |
|---|---|
| 4,4′-diazidodiphenylmethane | 3 g, and |
| cyclohexane | 50 g. |

The polymer used herein has a good transmission of 80% or more in the far ultraviolet range and at 248 nm as is shown in Fig. 2 in which the ultraviolet spectroscopy of the polymer at the thickness of 1 µm is given.

The present composition was coated onto substrate 1. After baking thus prepared coating in an oven at 80 °C for 20 minutes, the resist film 20 having the thickness of 1.0 µm was obtained. The transmission of 248 nm rays of the thus formed resist film was 42% (Fig. 1a). Then, KrF excimer laser rays 5 were selectively exposed to the film through a mask by use of a KrF excimer laser stepper (248 nm, NA: 0.35) (Fig. 1b). The amount of the exposure was 210 $mJ/cm^2$ and the transmission of 248 nm rays of the thus treated film was 82%. Thereafter, by performing immersion development with Alkali Developer NMD-3 (mfd. by Tokyo Applied chemistry Co., Ltd.) 20% aqueous solution for 60 seconds, resist pattern 2A was obtained (Fig. 1c).

The resist pattern 2A had a good shape showing an aspect ratio of 82°, free from film loss irrespective of the size of patterns, e.g., both 1 µm and 0.5 µm pattern.

The similar results can be obtained by using the polymers having the following structural unit:

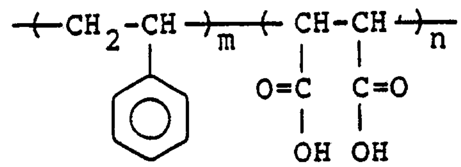

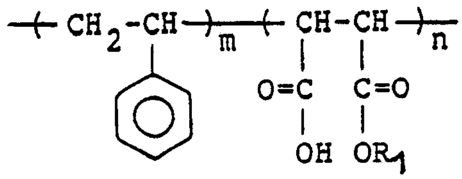

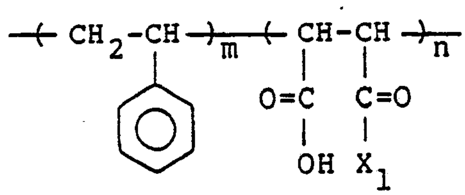

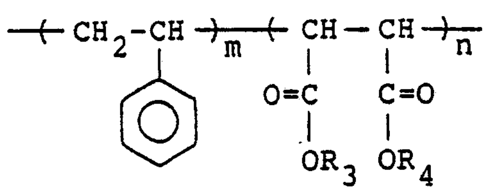

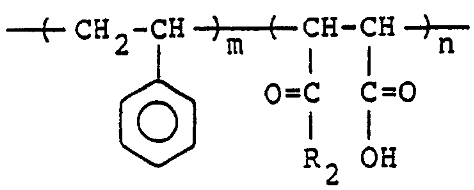

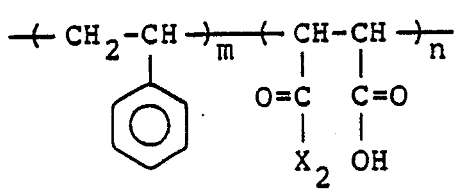

wherein $R_1$, $R_2$, $R_3$ and $R_4$ are respectively alkyl groups such as methyl, isopropyl, ethyl, tert-butyl, heptyl and the like; aryl groups which may have substituent(s) such as $C_1$-$C_4$ alkyl group, a halogen atom; alkenyl groups; and alkinyl groups, and $X_1$ and $X_2$ are respectively halogen atoms such as F, Cl, Br or the like.

Example 2

A good resist pattern similar to that of Example 1 was obtained by repeating the procedure of Example 1 except that the following composition of pattern forming material was used and the exposure amount was 225 mJ/cm$^2$.

A polymer having the structural unit of

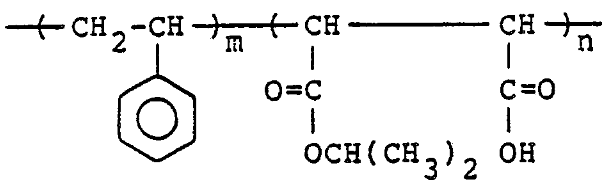

10 g,

wherein m to n is 3 : 2 and the molecular weight is 5500

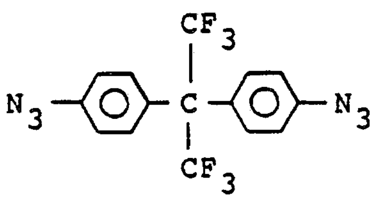

2.5 g, and

cyclopentanone 47 g

Example 3

A good resist pattern similar to that of Example 1 was obtained by repeating the procedure of Example 1 except that the following composition of pattern forming material was used and the exposure amount was 250 mJ/cm$^2$.

A polymer having the structural unit of

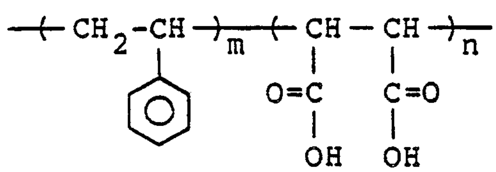

10 g,

wherein m to n is 1 : 1 and the molecular weight of 4500

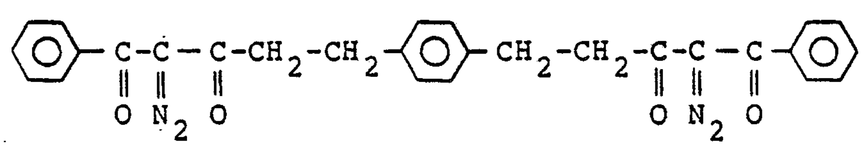

3.5 g, and

Ethylcellosolve 50 g

Example 4

A good resist pattern similar to that of Example 1 was obtained by repeating the procedure of Example 1 except that the following composition of pattern forming material was used and the exposure amount was 240 mJ/cm$^2$:

A copolymer having the following structural unit of

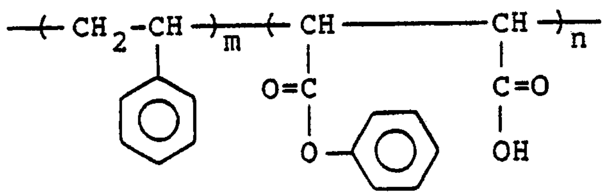

12 g,

wherein m to n is 1 : 1 and the molecular weight of 6000

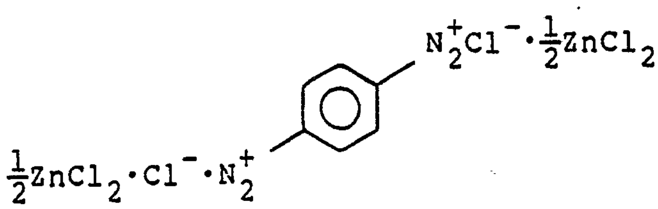

3 g, and

Diethylene glycol dimethyl ether 45 g.

Example 5

A good resist pattern similar to that of Example 1 was obtained by repeating the procedure of Example 1 except that the following composition of the pattern forming material was used and the exposure amount was 200 mJ/cm$^2$:

A copolymer having the following structural unit of

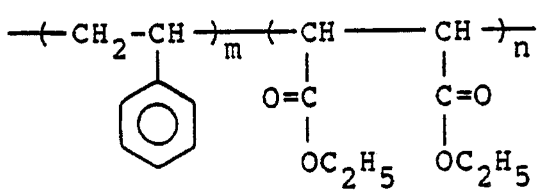

12 g,

in which m to n is 1 : 1 and the molecular weight of 6000

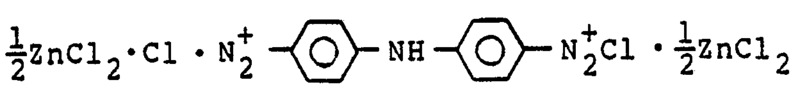

3.5 g, and

Cyclopentanone 45 g.

Example 6

Another embodiment of the present composition will be explained hereinafter.

A composition for pattern forming material was prepared by mixing 10 g of polyvinyl phenol resin (Resin M, mfd. by Maruzen Petroleum Co., Ltd.), 0.1 g of acridine and 30 g of diethyleneglycol.

Thus prepared composition was coated onto substrate. Next, the coating thus prepared was prebaked on a hotplate at 90 °C for 2 minutes to give the resist film of 1.0 µm thickness. Thereafter, the resist film was selectively exposed to KrF excimer laser ray at the energy of 100 mJ/cm$^2$ through a mask by use of KrF excimer laser stepper (249 nm, NA 0.35). Then, with immersion development in an alkali developer (0.27 N aqueous solution) for 40 seconds, whereby the pattern was formed. The pattern formed was of good resolution, one of 0.1 µm.

An acridine derivative such as acridine orange, acridine yellow or the like can also give a good pattern similar to the one obtained using acridine.

Example 7

Further other embodiment of the present composition will be illustrated with referring to Fig. 3.

A composition for pattern forming material was prepared by mixing the following materials:

A polymer having the structural unit of

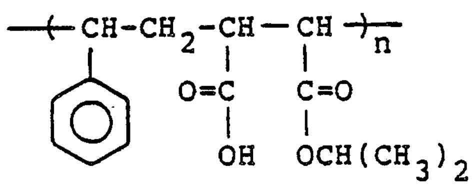

2.0 g,

wherein n is an integer and the molecular weight of about 4000

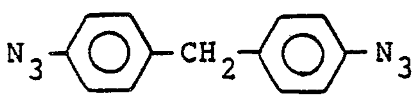

0.9 g, and

Diethyleneglycol dimethyl ether 10 0 ml.

The thus prepared composition was coated in the thickness of 1.2 µm onto substrate 1 (The substrate may be a semiconductor or the like) so as to form coating 3 (Fig. 3a). Next, the coating layer was selectively exposed to rays 5 through a mask by the use of a KrF excimer laser ray stepper (NA: 0.36) (Fig. 3b). Thereafter, with immersion development in 10% NMD03 (mfg. by Tokyo Applied Chemistry Co., Ltd.) aqueous solution, pattern 3A was formed (Fig. 3c).

Thus obtained pattern 3A was of good line-and-space of 0.5 µm showing an aspect ratio of 88° and film loss of 0, being free from inverted trapezoid shape pattern.

## Claims

1. A composition for forming pattern materials comprising a copolymer of styrene and a maleic acid derivative or maleic acid, and a cross-linkable photosensitive substance.

2. A composition for forming pattern materials comprising a polymer selected from the group consisting of novolak resins, phenolic resins, maleimide resins and copolymers of styrene and a maleic acid derivative or maleic acid, and at least one member selected from the group consisting of acridine and its derivatives.

3. The composition according to Claim 2, wherein said acridine derivatives are the one selected from acridine orange and acridine yellow.

4. The composition according to Claim 1 or Claim 2, wherein said copolymer of styrene and the maleic acid derivative or maleic acid is the one having the following structural unit in the molecule:

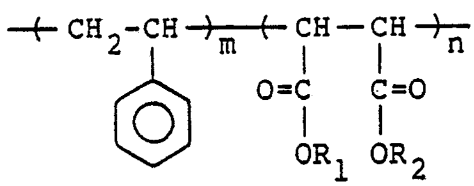

or

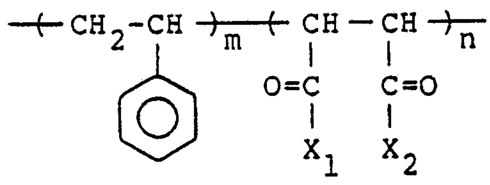

wherein $R_1$ and $R_2$ denote respectively a hydrogen action, an alkyl group, an aryl group which may have a substituent(s), a cycloalkyl group, an alkenyl group and an alkinyl group; at least one of $X_1$ and $X_2$ is halogen atoms and the rest is $-OR_1$ or $-OR_2$ radical and m and n are both any integer.

5. The composition according to Claim 1, wherein said cross-linkable photosensitive substance is one member selected from the group consisting of azido compounds, diazonium compounds and diazo compounds.

6. The composition according to Claim 1, wherein said azido compounds are the ones shown by the following general formula:

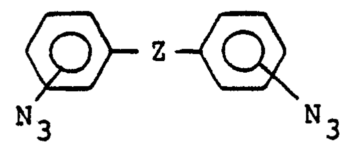

wherein Z is -CH -,

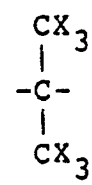

(in which X is a hydrogen or halogen atom), -S-,

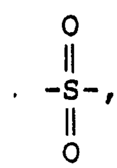

$-CH_2CH_2-$, $-CH=CH-$, -S-S-, or

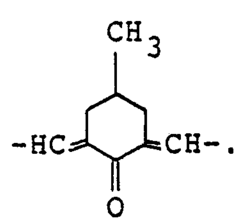

7. The composition according to Claim 1, wherein the melting point of said cross-linkable photosensitive substance is at the maximum equal to or lower than the temperature of prebaking the composition at the time of forming a layer thereof on a substrate.

FIG. 1(a)

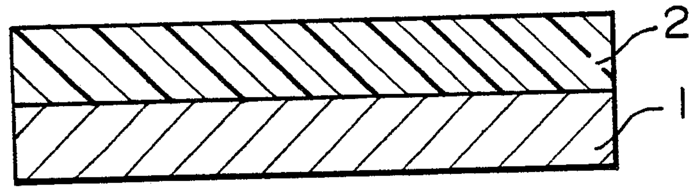


FIG. 1(b)

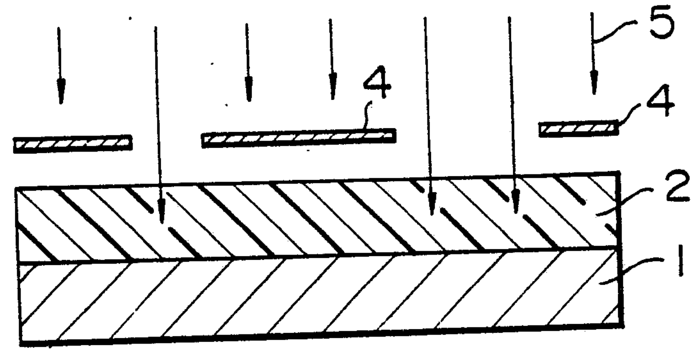


FIG. 1(c)

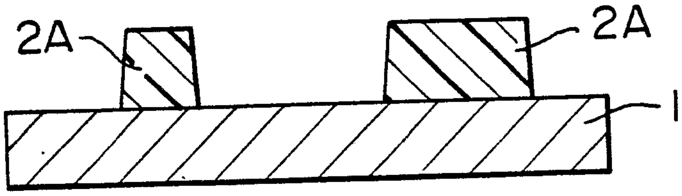

FIG. 2

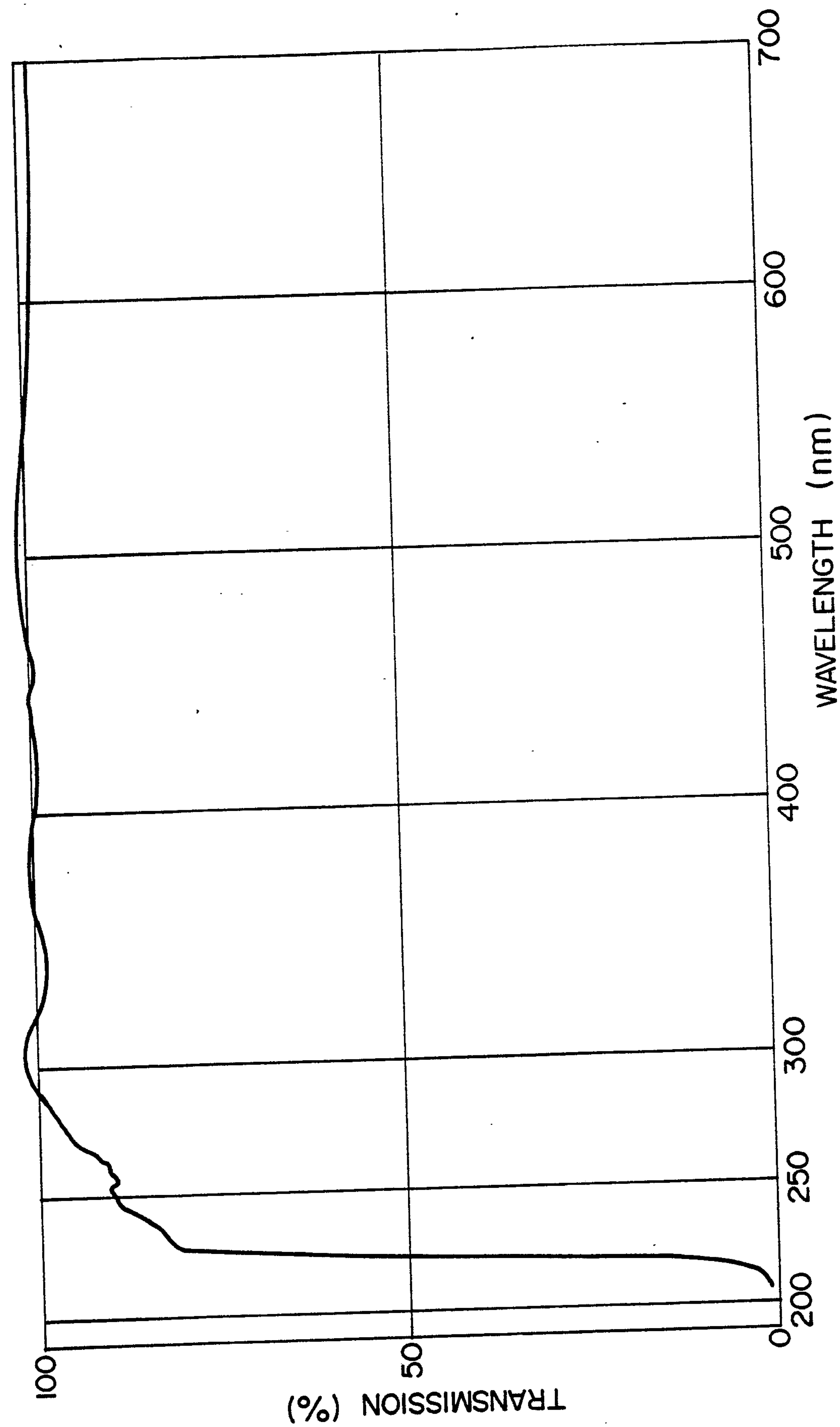
100
50
0
TRANSMISSION (%)
200
250
300
400
500
600
700
WAVELENGTH (nm)

FIG. 3(a)

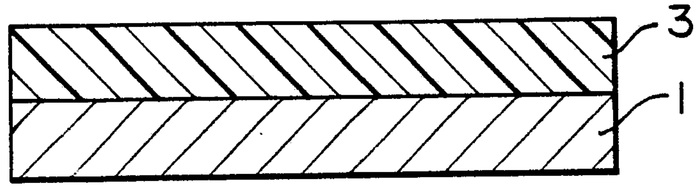


FIG. 3(b)

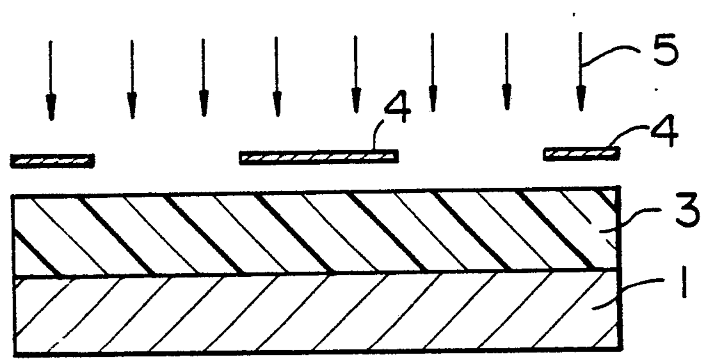


FIG. 3(c)

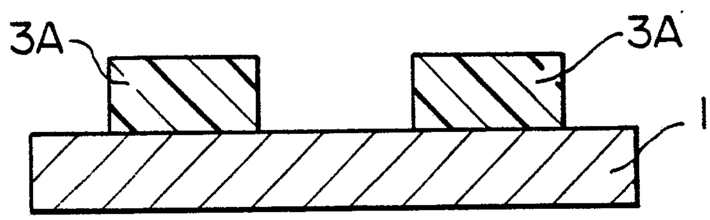

FIG. 4(a)

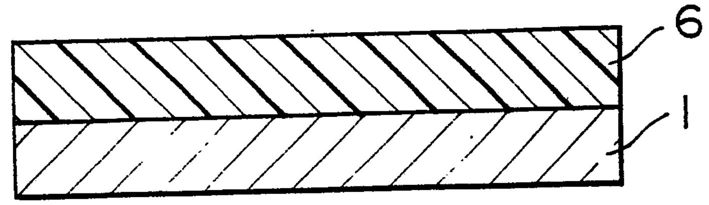


FIG. 4(b)

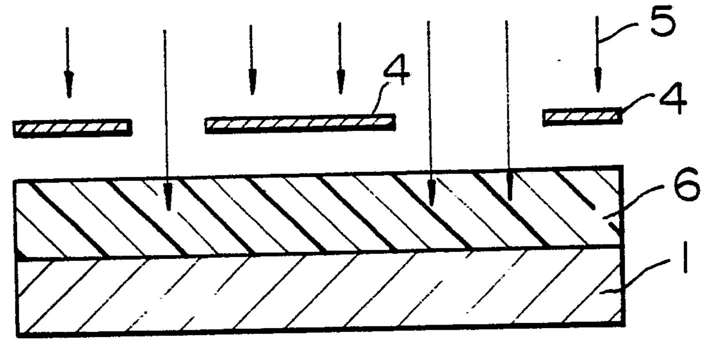


FIG. 4(c)